## Europäisches Patentamt

(19) **European Patent Office**

**Office européen des brevets**

(11) Veröffentlichungsnummer: **0 224 471**
**B1**

(12) **EUROPÄISCHE PATENTSCHRIFT**

(45) Veröffentlichungstag der Patentschrift:
06.09.89

(51) Int. Cl.⁴: **G 01 R 1/073**

(21) Anmeldenummer: **86890325.3**

(22) Anmeldetag: **20.11.86**

(54) Vorrichtung zum Prüfen von Leiterplatten.

(30) Priorität: **26.11.85 AT 3447/85**

(73) Patentinhaber: **Alcatel Austria Aktiengesellschaft, Scheydgasse 41, A-1210 Wien (AT)**

(43) Veröffentlichungstag der Anmeldung:
**03.06.87 Patentblatt 87/23**

(72) Erfinder: **Bonifert, Reinhard, Dr. V. Adlerstrasse 40, A-2000 Stockerau (AT)**
Erfinder: **Hainzl, Helmut, Wenhartgasse 27-29, A-1210 Wien (AT)**

(45) Bekanntmachung des Hinweises auf die Patenterteilung:
**06.09.89 Patentblatt 89/36**

(84) Benannte Vertragsstaaten:
**BE CH DE FR GB LI NL SE**

(56) Entgegenhaltungen:
**DE-A- 2 051 052**
**DE-A- 2 707 900**
**FR-A- 2 524 649**

## Beschreibung

Die Erfindung bezieht sich auf eine Vorrichtung zum Prüfen von Leiterplatten für elektronische Schaltungen, mit an einer Kontaktträgerplatte in vorgegebener Verteilung angeordneten, federbelasteten Kontaktstiften und einer Selektierplatte, die der zu prüfenden Art von Leiterplatten entsprechend im zusammengebauten Zustand der Vorrichtung bestimmte Kontaktstifte gegenüber den anderen vorstehen läßt, und wobei zur Durchführung der Prüfung die vorstehenden Kontaktstifte zur Anlage an der Leiterplatte bringbar und leitend mit einem Prüfgerät verbindbar sind.

Vorrichtungen zum Prüfen von Leiterplatten durch elektrisches Kontaktieren bestimmter Kontaktstellen über mit einem Prüfgerät verbindbare Taststifte sind in verschiedenen Ausführungen bekannt, siehe dazu beispielsweise DE-B-2 657 910, DE-B-2 243 457, DE-A-3 311 977, CH-A-633 403. Bei allen diesen genannten Vorrichtungen sind Kontaktträgerplatten im Einsatz, die zufolge von fix vorgegebenen Anordnungen der Kontaktstifte nur jeweils für eine einzelne Art von Leiterplatten verwendbar sind bzw. (siehe z.B. die genannte DE-B-2 243 457) zumindest sehr aufwendige Vorkehrungen beim Umrüsten auf eine andere Art von zu prüfenden Leiterplatten erfordern. Es entstehen dadurch relativ hohe Kosten für die Herstellung der jeweils prüfungspezifischen Austauschteile bzw. für die Umrüstung der Vorrichtung, was sich insbesondere bei geringeren Stückzahlen der herzustellenden bzw. zu prüfenden Leiterplatten sehr nachteilig auswirkt.

Als weiterer Nachteil der obigen bekannten Vorrichtungen ist zu nennen, daß dort die auf die zu prüfende Leiterplattenart abgestellte Anordnung der Kontaktstifte in der Kontaktträgerplatte eine separate Verdrahtung jedes Kontaktstiftes mit dem Prüfgerät bzw. mit einem zum Anschluß des Prüfgerätes dienenden Adapter erforderlich macht, was trotz Anwendung beispielsweise der sogenannten Wire Wrap-Technik ziemlichen Aufwand verursacht und darüber hinaus auch störanfällig ist. Weiters sind die für eine bestimmte Art von Leiterplatten erforderlichen Austauschsätze bei diesen Vorrichtungen recht voluminös, was sehr schnell Probleme bei der für verschiedene Anwendungsfälle oft über Jahrzehnte erforderlichen Lagerung der Austauschsätze für Nachlieferung bzw. Reparatur mit sich bringt.

Weiters sind in jüngster Zeit Vorrichtungen der eingangs genannten Art bekannt geworden (siehe z.B.: DE-A-2 707 900), bei denen die Kontaktstifte an der Kontaktträgerplatte in vorgegebener Verteilung — meist in einem regelmäßigen Raster mit genormtem Abstand (Modul) — angeordnet sind. Die Auswahl der zum Prüfen einer speziellen Art von Leiterplatten jeweils erforderlichen Kontaktstifte erfolgt über eine Selektierplatte, welche mit feststehenden Selektierstiften versehen ist. Diese Selektierstifte sind auch entsprechend der Grundmatrix angeordnet, jedoch nur an den Stellen, wo die Kontaktstifte, die für die jeweilige Prüfung erforderlich sind, sitzen. Im zusammengebauten Zustand von Kontaktträgerplatte und Selektierplatte werden dadurch die für die Prüfung erforderlichen Kontaktstifte aus der Ebene der übrigen Kontaktstifte hervorgehoben und kommen mit der zumeist über eine Unterdruck erzeugende Anordnung angedrückten Leiterplatte in Kontakt. Die Kontaktierung von den zur Prüfung der Leiterplatte verwendeten Kontaktstiften zum Prüfgerät bzw. zu einem Interface oder dgl. erfolgt bei diesen bekannten Anordnungen über eine Verdrahtung der einzelnen Selektierstifte, was in dieser Hinsicht wiederum die oben bereits angesprochenen Nachteile ergibt.

Bei der zuletzt angesprochenen bekannten Ausbildung sind also die Anzahl und die Kompliziertheit der für jede Art von zu prüfenden Leiterplatten separat erforderlichen Austauschteile der Vorrichtung verringert. Neben dem bereits genannten Nachteil der Verdrahtung sind aber auch hinsichtlich der Lagerung der Austauschteile nach wie vor ähnliche Probleme wie bei den obenstehend besprochenen anderen Vorrichtungen gegeben, da die Selektierplatte mit den Selektierstiften zur Vermeidung von Beschädigungen entweder entsprechend verpackt oder mit Abstand zu anderen Einrichtungen gelagert werden muß.

Als weiterer Nachteil ist noch die Tatsache anzusehen, daß die vorstehenden Stifte an der Selektierplatte eine automatische Umrüstung der Vorrichtung zum Prüfen eines anderen Typs von Leiterplatten sehr erschweren bzw. in der Praxis verhindern, so daß eine aufwendige manuelle Umrüstung durchgeführt werden muß.

Aufgabe der vorliegenden Erfindung ist es, eine Vorrichtung der eingangs genannten Art so zu verbessern, daß die genannten Nachteile der bekannten Vorrichtungen nicht auftreten und daß insbesonders die Herstellung und die Umrüstung der für verschiedene Arten von zu prüfenden Leiterplatten auszutauschenden Teile der Vorrichtung einfach und kostengünstig wird. Weiters soll auch die Ausbildung der erforderlichen Austauschteile so erfolgen, daß eine einfache und platzsparende Lagerung ohne die Gefahr einer Beeinträchtigung der Funktion sichergestellt werden kann.

Diese Aufgabe wird bei einer Vorrichtung der eingangs genannten Art gemäß der vorliegenden Erfindung dadurch gelöst, daß die Selektierplatte an mit den vorstehenden Kontaktstiften zusammenwirkenden Stellen Kontakte aufweist, die über auf der Selektierplatte angebrachte Leiterbahnen mit dem Prüfgerät verbindbar sind, und daß an den mit den anderen Kontaktstiften zusammenwirkenden Stellen gegenüber den dortigen Abmessungen der anderen Kontaktstifte vergrößerte Ausnehmungen in der Selektierplatte vorgesehen sind. Damit ist nun erreicht, daß die Selektierplatte als einzig wesentlicher, für verschiedene Arten von zu prüfenden Leiterplatten auszutauschender Bauteil keinerlei Erhebungen, Stifte oder dgl. aufweist, was vorerst auf sehr einfache Weise eine raumsparende Lagerung dieser Austauschteile ermöglicht. Zufolge der vorgesehenen Art der Herstellung des erforderlichen Kontakts von den Kontaktstiften zum Prüfgerät ist auch eine sehr einfache Herstellung der Selektierplatte unter Zuhilfenahme der gleichen Techniken wie zur Herstellung der Leiterplatten selbst — ätzen, leitend beschichten, usw. — möglich, was eine umständliche Verdrahtung überflüssig macht. Ein sehr wesentlicher Vorteil ergibt sich weiters daraus, daß die bis auf die Kontakte samt zugehörigen Leiterplatten völlig ebene Oberfläche der Selektierplatte auch eine automatische Umrüstung der Vorrichtung zum Prüfen von anderen Arten von Leiterplatten ermöglicht, da nun nicht auf vorstehende Stifte oder andere empfindliche Erhebungen oder dgl. Rücksicht genommen werden muß.

Gemäß einer bevorzugten Ausgestaltung der Erfindung ist vorgesehen, daß die Selektierplatte Durchgangsbohrungen aufweist, deren Bohrbild der Anordnungsmatrix der Kontaktstifte der Kontaktträgerplatte entspricht, wobei die mit den jeweils vorstehenden Kontaktstiften zusammenwirkenden Kontakte auf der Selektierplatte von leitenden Verschlüssen der zugehörigen Bohrungen gebildet sind. Dadurch kann eine weitere Vereinfachung der Herstellung der Vorrichtung und insbesonders der austauschbaren Selektierplatte erreicht werden, da sich die anzubringenden Kontakte für die jeweils vorstehenden Kontaktstifte von den Durchgangslöchern im wesentlichen nur durch die leitenden Verschlüsse unterscheiden.

In diesem Zusammenhang kann gemäß einer weiteren Ausgestaltung auch vorgesehen sein, daß die leitenden Verschlüsse von zugelöteten Durchkontaktierungen gebildet sind, was sowohl eine einfache Herstellbarkeit als auch ein zuverlässiges Funktionieren der Vorrichtung sicherstellt.

Nach einer weiteren Ausgestaltung der Erfindung können die auf der Selektierplatte an deren den Kontaktstiften abgewandten Oberfläche aufgebrachten Leiterbahnen über die Durchkontaktierungen mit den Kontakten auf der anderen Oberfläche verbunden sein, was sehr robuste Kontakte an der Selektierplatte und eine zuverlässige Verbindung mit den Leiterbahnen zum Prüfgerät bzw. zum Adapter ermöglicht.

Eine einfache Ausgestaltung besteht weiterhin darin, daß die für die Prüfung erforderlichen Abgriffe über auf der Selektierplatte angebrachte Leiterbahnen an den Rand der Selektierplatte herausgeführt sind. damit werden nicht nur die Herstellungskosten niedrig gehalten, sondern es zeichnen sich die Selektierplatten auch dadurch aus, daß sie praktisch keine über ihre Oberfläche vorstehende Teile aufweisen.

In weiterer Ausgestaltung der Erfindung sind die jeweils vorstehenden Kontaktstifte im prüffertig eingebauten Zustand von Kontaktträgerplatte und Selektierplatte federnd gegen die Kontakte der Selektierplatte vorgespannt, was auf einfache Weise ein sicheres Kontaktieren zwischen den für die Prüfung jeweils erforderlichen Kontaktstiften und den zugehörigen Kontakten an der Selektierplatte sicherstellt.

Die Erfindung wird im folgenden an Hand der Zeichnung näher erläutert. Fig. 1 zeigt eine Prinzipskizze eines Ausführungsbeispiels der erfindungsgemäßen Vorrichtung, Fig. 2 zeigt einen teilweisen schematischen Schnitt durch ein anderes Ausführungsbeispiel nach der Erfindung und Fig. 3 zeigt eine Prinzipskizze einer weiteren Ausführung nach der Erfindung mit einer Anordnung zum automatischen Austausch der Selektierplatten.

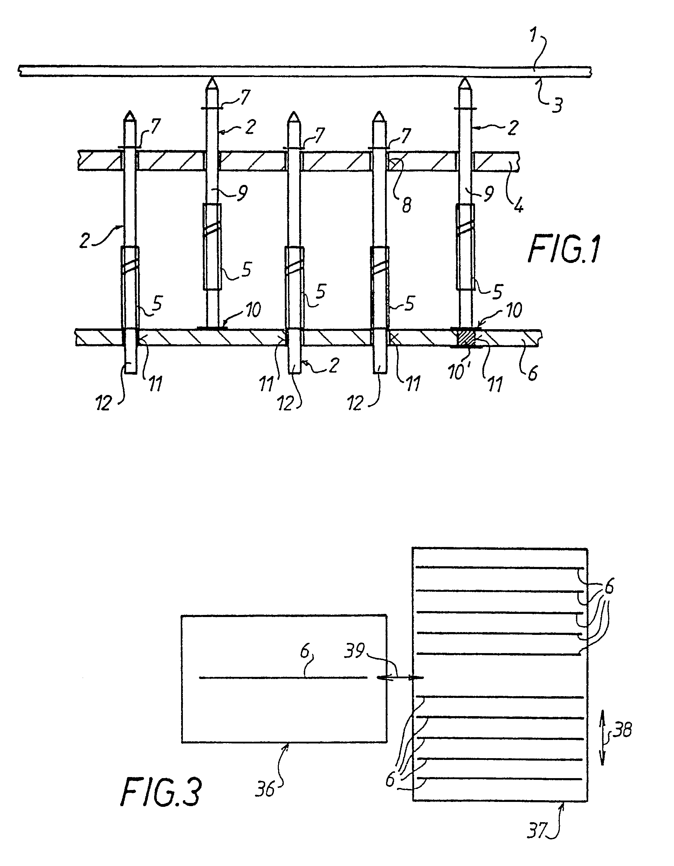

Die in Fig. 1 schematisch dargestellte Vorrichtung dient zum Prüfen einer Leiterplatte 1, wie sie in heutzutage immer mehr steigendem Ausmaß zum Aufbau von elektronischen Schaltungen oder dgl. Verwendung finden. Diese Leiterplatte 1 trägt in hier nicht dargestellter Weise zumindest auf einer ihrer Oberflächen — hier zumindest auf der den Kontaktstiften 2 zugewandten Oberfläche 3 — Leiterbahnen, welche in Druck- bzw. Ätztechnik angefertigt werden.

Die eigentliche Vorrichtung zum Prüfen der Leiterplatte 1 besteht im wesentlichen aus einer Kontaktträgerplatte 4 mit in vorgegebener, hier regelmäßiger, Verteilung angeordneten, über eine Federhülse 5 in ihrer Länge vorspannbaren Kontaktstiften 2, einer Selektierplatte 6, sowie einem hier nicht weiter dargestellten Prüfgerät. Die Kontaktstifte 2 sind in der dargestellten Ausführung jeweils über einen Bund 7 sowie die Federhülse 5 unverlierbar in Bohrungen 8 der Kontaktträgerplatte 4 geführt, wobei diese Bohrungen 8 in einer regelmäßigen Gittermatrix angeordnet sind, deren Maschenweite einem bestimmten sogenannten Modul entspricht, der mit der Matrix bzw. dem Modul der gedruckten oder geätzten Schaltung auf der Leiterplatte 1 korrespondiert. Die Federhülsen 5 können aber auch in die Kontaktträgerplatte fest eingesetzt sein, wobei dann in beide Enden der Federhülse 5 federnde Kontaktstifte eingesetzt sind.

Um aus der regelmäßigen Anordnung der Kontaktstifte 2 diejenigen auswählen bzw. hervorheben zu können, welche für die Prüfung eines bestimmten Typs von Leiterplatten benötigt werden, weist die Selektierplatte 6 an mit den hervorzuhebenden, dann gegenüber den anderen Kontaktstiften vorstehenden, Kontaktstiften 9 zusammenwirkenden Stellen Kontakte 10 auf, welche über auf der Selektierplatte 6 angebrachte, hier nicht weiter dargestellte Leiterbahnen mit dem Prüfgerät in Verbindung stehen und somit über die dort anliegenden Kontaktstifte 9 eine Kontaktierung der jeweils gewünschten Stellen an der Leiterplatte 1 ermöglichen. Damit kann beispielsweise überprüft werden, ob eine bestimmte Leiterbahn, die an der Leiterplatte 1 zwischen den Punkten, wo die Kontaktstifte 9 anliegen, verläuft, durchgehend und intakt ist bzw. ob die zwischen diesen Punkten eingeschalteten Bauelemente richtig funktionieren. Die für die jeweilige Prüfung bzw. den jeweils zu prüfenden Typ von Leiterplatten nicht benötigten anderen Kontaktstifte 2 wirken mit Stellen der Selektierplatte 6 zusammen, welche gegenüber den dortigen Abmessungen der Kontaktstifte 2 vergrößerte Durchgangsbohrungen 11 aufweisen, so daß die unteren Enden 12 dieser Kontaktstifte 2 durch die Selektierplatte 6 berührungslos durchgehen und erst durch Anschläge oder dgl. — hier durch die Federhülsen 5 bzw. die Bünde 7 — aufgehalten werden.

Die besprochene und schematisch dargestellte Anordnung hat den wesentlichen Vorteil, daß zum Umrüsten der Vorrichtung für die Prüfung einer anderen Art von Leiterplatten lediglich die bis auf die Kontakte 10 und die zugehörigen Leiterbahnen völlig ebene und ansonsten nur die Durchgangsbohrungen 11 als Unterbrechung der ebenen Oberfläche aufweisende Selektierplatte 6 ausgetauscht werden muß, was gemäß der gezeigten Prinzipskizze sehr einfach nach entsprechender Vergrößerung des Relativabstandes zwischen Kontaktträgerplatte 4 und Selektierplatte 6 erfolgen kann. Verschiedene solcher Selektierplatten können auf sehr einfache und platzsparende Weise praktisch direkt aneinanderliegend gestapelt werden, so daß sich neben der Erleichterung der Umrüstung der Vorrichtung auch eine vereinfachte Lagerhaltung ergibt.

Beim linken der beiden von der Selektierplatte 6 hervorgehobenen Kontaktstifte 9 ist der Kontakt 10 einfach auf die Oberseite der Selektierplatte aufgebracht und auch unmittelbar mit dort verlaufenden, nicht weiter dargestellten Leiterbahnen in Verbindung. Demgegenüber ist beim rechten hervorgehobenen Kontaktstift 9 eine Ausbildung dargestellt, gemäß welcher die Selektierplatte 6 im gleichen Bohrungsmuster wie die Kontaktträgerplatte 4 mit Durchgangsbohrungen 11 versehen ist, wobei die mit den jeweils vorstehenden Kontaktstiften 9 zusammenwirkenden Kontakte 10 von leitenden Verschlüssen 10' der zugehörigen Bohrungen 11 gebildet sind. Diese leitenden Verschlüsse 10 können auf sehr einfache Weise von zugelöteten Durchkontaktierungen gebildet sein. Bei dieser Ausführung können wahlweise auch auf der der Kontaktträgerplatte 4 abgewandten Oberfläche der Selektierplatte 6 Leiterbahnen angebracht sein.

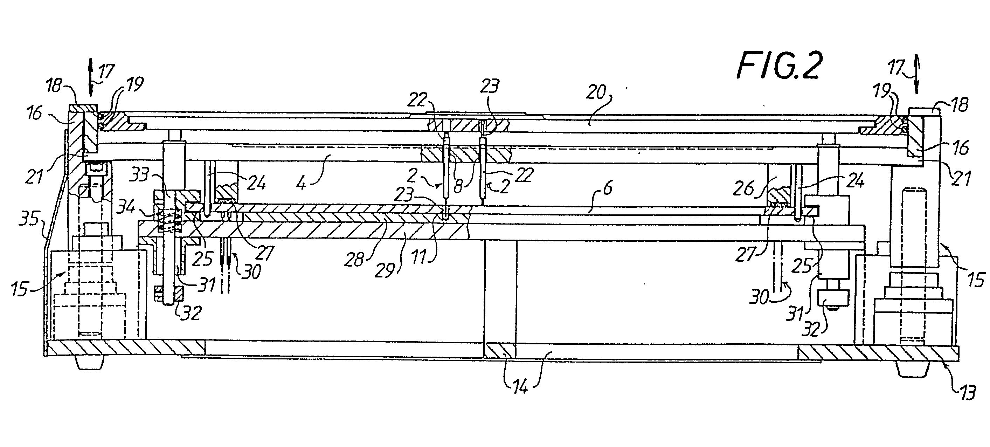

Bezüglich weiterer Details der in Fig. 1 nur im Prinzip dargestellten Vorrichtung wird auf die nun folgende Beschreibung der Fig. 2 verwiesen, die eine vollständige Vorrichtung zum Prüfen von Leiterplatten zeigt.

Auf einem Grundrahmen 13, der als Verstärkung Mittelstege 14 aufweist, sind im dargestellten Ausführungsbeispiel pneumatisch betätigte Fluidzylinder-Anordnungen 15 angebracht, welche zum Anheben und Absenken eines Tragerahmens 16 in Richtung der Pfeile 17 dienen. Der Tragerahmen 16 ist über Leisten 18 befestigt und führt an seinem Innenrand einen über Dichtungen 19 abgedichteten Auflagerahmen, der seinerseits eine eingelegte Trägerplatte 20 an deren Rand hält. Diese Trägerplatte 20 dient im Betrieb der Vorrichtung als Auflage und Abdichtung für die zu prüfenden, hier nicht dargestellten Leiterplatten.

Unterhalb der Trägerplatte 20 ist die Kontaktträgerplatte 4 angebracht, die an ihrem Rand 21 über den Tragerahmen 16 bzw. die Leisten 18 an der Fluidzylinder-Anordnung 15 befestigt ist. In Bohrungen 8 der Kontaktträgerplatte 4 sind wiederum in regelmäßiger Verteilung (Matrixgitter mit einem Modul als Maschenweite) die Kontaktstifte 2 eingesetzt, die hier eine in der Bohrung 8 feststehende Außenhülse 22 aufweisen, in der oben und unten je ein Stift 23 in Längsrichtung federnd verschiebbar geführt ist.

Unterhalb der Kontaktträgerplatte 4 ist die Selektierplatte 6 angeordnet, die über Fangstifte 24 in ihrer relativen Lage zur Kontaktträgerplatte 4 fixiert ist und nach Abheben der Kontaktträgerplatte 4 samt Trägerplatte 20 über die Fluidzylinder-Anordnungen 15 entlang der Führungsbahnen 25 herausgezogen und ausgewechselt werden kann. Innerhalb der Fangstifte 24 ist auch ein umlaufender Distanzring 26 mit Dichtung 27 zu erkennen, der die Abdichtung des Raumes zwischen der Kontaktträgerplatte 4 und der Selektierplatte 6 ermöglicht.

Unterhalb der Selektierplatte 6 ist eine Abdichtplatte 28 vorgesehen, die unmittelbar auf einem Auflagetisch 29 der Vorrichtung aufliegt und die Durchgangsbohrungen 11 der Selektierplatte 6 abdichtet. Der Auflagetisch 29 weist die Anschlußkontakte 30 auf, welche in hier nicht näher dargestellter Weise mit den Leiterbahnen auf der Selektierplatte 6 zusammenwirken und den Anschluß eines Prüfgerätes erlauben.

An den äußeren Enden des Auflagetisches 29 sind Kugelführungen 31 für Endanschläge 32 tragende Führungsstangen 33 angebracht, wobei um diese Führungsstangen 33 Rückstellfedern 34 vorgesehen sind, die zwischen dem die Führungsbahnen 25 für die Selektierplatte 6 tragenden Bauteil einerseits und dem Auflagetisch 29 anderseits wirken. Der Vollständigkeit halber ist auch noch auf eine nur auf der linken Seite der Fig. 2 dargestellte Abdeckung 35 zu verweisen, die am Grundrahmen 13 befestigt ist und die Fluidzylinder-Anordnungen 15 übergreift.

Vor Inbetriebnahme der dargestellten Vorrichtung ist der obere Teil derselben samt Trägerplatte 20 und Kontaktträgerplatte 4 unter Einwirkung der Rückstellfedern 34 angehoben. Dabei kann — händisch oder automatisch — eine Selektierplatte 6 in die Führungsbahnen 25 eingeschoben werden. Danach erfolgt über die Fluidzylinder-Anordnungen 15 das Absenken des oberen Teils der Vorrichtung samt Trägerplatte 20 und Kontaktträgerplatte 4, wobei die Fangstifte 24 in zugehörige Bohrungen an den Rändern der Selektierplatte 6 eingreifen und diese exakt ausrichten. Die Stifte 23 der Kontaktstifte 2 können nun dort, wo in der Selektierplatte 6 Durchgangsbohrungen 11 vorgesehen sind, die Selektierplatte 6 durchdringen. An den übrigen Stellen des Zusammenwirkens von Kontaktstiften 2 mit der Oberfläche der Selektierplatte 6 sind Kontakte und zugehörige Leiterbahnen angebracht, welche über die Anschlußkontakte 30 eine Verbindung vom nicht dargestellten Prüfgerät zu den zu kontaktierenden Stellen an der zu prüfenden Leiterplatte ermöglichen. Nach dem Auflegen der zu prüfenden Leiterplatte wird der Raum unterhalb derselben bis zur Abdichtplatte 28 evakuiert, wobei sich die Trägerplatte 20 samt aufgelegter Leiterplatte relativ zur Kontaktträgerplatte 4 bzw. zu den Kontaktstiften 2 absenkt und ein sicheres Kontaktieren der entsprechenden Punkte an der Leiterplatte durch die vorstehenden Kontaktstifte erfolgt. Nach Durchführung der Prüfung über das Prüfgerät wird das Vakuum wieder aufgefüllt, worauf die Trägerplatte 20 durch nicht eigens dargestellte Rückstellfedern wieder angehoben wird und die geprüfte Leiterplatte abgenommen werden kann.

In Fig. 3 ist die Vorrichtung nach Fig. 2 nur schematisch dargestellt und mit 36 bezeichnet. Neben dieser Vorrichtung 36 ist ein Stapelmagazin 37 angeordnet, welches in Richtung des Doppelpfeiles 38 relativ zur Vorrichtung 36 bewegbar ist und je nach Stellung eine bestimmte Selektierplatte 6 zum automatischen Einzug in die Vorrichtung 36 (bzw. in die Führungsbahnen 25 gemäß Fig. 2) bereitstellt. Die Bewegung der ausgewählten Selektierplatte 6 entlang des Pfeiles 39 kann dabei beispielsweise über einen Rollenantrieb oder dgl. erfolgen. Damit ist eine automatische Umrüstung der Vorrichtung 36 zum Prüfen verschiedener Arten von Leiterplatten möglich, was sehr wesentlich dadurch erleichtert wird, daß die Selektierplatten 6 keinerlei Erhebungen, Stifte oder dgl. aufweisen.

## Patentansprüche

1. Vorrichtung zum Prüfen von Leiterplatten (1) für elektronische Schaltungen, mit an einer Kontaktträgerplatte (4) in vorgegebener Verteilung angeordneten, federbelasteten Kontaktstiften (2,9) und einer Selektierplatte (6), die der zu prüfenden Art von Leiterplatten (1) entsprechend im zusammengebauten Zustand der Vorrichtung bestimmte Kontaktstifte (9) gegenüber den anderen vorstehen läßt, und wobei zur Durchführung der Prüfung die vorstehenden Kontaktstifte (9) zur Anlage an der Leiterplatte (1) bringbar und leitend mit einem Prüfgerät verbindbar sind, dadurch gekennzeichnet, daß die Selektierplatte (6) an mit den vorstehenden Kontaktstiften (9) zusammenwirkenden Stellen Kontakte (10) aufweist, die über auf der Selektierplatte (6) angebrachte Leiterbahnen mit dem Prüfgerät verbindbar sind, und daß an den mit den anderen Kontaktstiften zusammenwirkenden Stellen gegenüber den dortigen Abmessungen der anderen Kontaktstifte vergrößerte Ausnehmungen in der Selektierplatte (6) vorgesehen sind.

2. Vorrichtung nach Anspruch 1, dadurch gekennzeichnet, daß die Selektierplatte (6) Durchgangsbohrungen (11) aufweist, deren Bohrbild der Anordnungsmatrix der Kontaktstifte (2) der Kontaktträgerplatte (4) entspricht, wobei die mit den jeweils vorstehenden Kontaktstiften (9) zusammenwirkenden Kontakte (10) auf der Selektierplatte (6) von leitenden Verschlüssen (10') der zugehörigen Bohrungen (11) gebildet sind.

3. Vorrichtung nach Anspruch 2, dadurch gekennzeichnet, daß die leitenden Verschlüsse (10') von zugelöteten Durchkontaktierungen gebildet sind.

4. Vorrichtung nach Anspruch 3, dadurch gekennzeichnet, daß die auf der Selektierplatte (6) an deren den Kontaktstiften (2) abgewandter Oberfläche aufgebrachten Leiterbahnen über die Durchkontaktierungen mit den Kontakten (10) auf der anderen Oberfläche verbunden sind.

5. Vorrichtung nach einem der Ansprüche 1 und 4, dadurch gekennzeichnet, daß die für die Prüfung erforderlichen Abgriffe über auf der Selektierplatte (6) angebrachte Leiterbahnen an den Rand der Selektierplatte (6) herausgeführt sind.

6. Vorrichtung nach einem der Ansprüche 1 bis 5, dadurch gekennzeichnet, daß die jeweils vorstehenden Kontaktstifte (9) im prüffertig eingebauten Zustand von Kontaktträgerplatte (4) und Selektierplatte (6) federnd gegen die Kontakte (10) der Selektierplatte (6) vorgespannt sind.

## Claims

1. Equipment for the testing of printed circuit boards (1) for electronic circuits, with spring-loaded contact fingers (2, 9), arranged in pre-determined pattern at a contact bearing plate (4), and a contact selecting plate (6) which according to the type of printed circuit boards (1) to be tested in the assembled state lets certain contact fingers (9) protrude relative to the rest of them, whereby for the execution of the test the contact fingers (9) can be brought to the printed circuit board (1) and connected conductively with the test equipment, characterized in that contact selecting plate (6) exhibits at points interacting with the protruding contact fingers (9) contacts (10) which via printed circuits printed on contact selecting plate (6) can be connected with the test equipment, and that at points interacting with the other fingers relative to the dimensions of the contact fingers at these points enlarged recesses are provided in contact selecting plate (6).

2. Equipment according to claim 1, characterized in that contact selecting plate (6) exhibits through plated holes (11) the hole pattern of which is according to the matrix of the arrangement of the contact fingers (2) of contact bearing plate (4), whereby the contacts (10) interacting with the respective protruding contact fingers (9) at contact selecting plate (6) are produced by conductive plugs (10') of the respective through plated holes (11).

3. Equipment according to claim 2, characterized in that the conductive plugs (10') are formed by soldering-closed through plated holes.

4. Equipment according to claim 3, characterized in that the printed circuits printed onto the surface not facing the contact fingers (2) on contact selecting plate (6) are connected with the contacts (10) at the other surface via the through plated holes.

5. Equipment according to one of the claims 1 and 4, characterized in that the lead-outs required for the testing are drawn via the conductive paths printed onto contact selecting plate (6) out to the edge of contact selecting plate (6).

6. Equipment according to one of the claims 1 through 5, characterized in that the respective protruding contact fingers (9) in the ready-for-testing assembled state of contact bearing plate (4) and contact selecting plate (6) are spring-clamped against the contacts (10) of contact selecting plate (6).

## Revendications

1. Equipement pour le test de cartes de circuits imprimés (1) pour circuits électroniques, comportant des broches de contact (2, 9) sous tension élastique disposés dans un arrangement prédéterminé sur une plaque de support de contacts (4) et une plaque de sélection (6) qui, selon le type de carte à circuits imprimés (1) à tester, à l'état assemblé, laisse saillir certaines broches de contact (9) par rapport aux autres, de sorte que, pour l'exécution du test, les broches de contact saillantes (9) peuvent être appuyées contre la carte à circuits imprimés (1) et la connecter à un équipement de test, caractérisé en ce que la plaque de sélection (6) comporte, aux points coopérant avec les broches de contact saillantes (9), des zones de contact (10), lesquelles, par des circuits imprimés sur la plaque de sélection (6) peuvent être connectés à l'équipement de test, et en ce que, aux points coopérant avec les autres broches de contact (2), des évidements sont prévus dans la plaque de sélection (6), de dimensions supérieures par rapport à celles des broches de contact (2).

2. Equipement conforme à la revendication 1, caractérisé en ce que la plaque de sélection (6) comporte des trous métallisés (11) dont la configuration correspond à l'arrangement matriciel des broches de contact (2) de la plaque de support de contact (4), de sorte que les zones de contact (10) coopérant avec les broches de contact saillantes respectives (9) sont produites sur la plaque de sélection (6) par des fiches conductrices (10') des trous métallisés respectifs (11).

3. Equipement conforme à la revendication 2, caractérisé en ce que les fiches conductrices (10') sont formées par des trous métallisés remplis de soudure.

4. Equipement conforme à la revendication 3, caractérisé en ce que les circuits imprimés portés par la face de la plaque de sélection (6) opposée aux broches de contact (2) sont connectés aux zones de contact (10) de l'autre face via les trous métallisés.

5. Equipement conforme aux revendications 1 et 4, caractérisé en ce que les prises nécessaires pour les tests sont étendues, par l'intermédiaire des trajets conducteurs imprimés sur la plaque de sélection (6), jusqu'au bord de la plaque de sélection (6).

6. Equipement conforme à l'une quelconque des revendications 1 à 5, caractérisé en ce que les broches de contact saillantes respectives (9), lorsque la plaque support de contact 4 et la plaque de sélection sont dans l'état assemblé, prêtes pour le test, sont sollicitées élastiquement vers les zones de contact (10) de la plaque de sélection (6).

FIG.1

FIG.3

*FIG.2*

EP 0 224 471 B1